(19)

Europäisches
Patentamt
European
Patent Office
Office européen
des brevets

(11)  **EP 1 372 264 B1**

(12)  **EUROPEAN PATENT SPECIFICATION**

(45) Date of publication and mention
of the grant of the patent:
**30.07.2008 Bulletin 2008/31**

(51) Int Cl.:
*H03H 17/06* (2006.01)

(21) Application number: **03006956.1**

(22) Date of filing: **26.03.2003**

(54) **Low power decimation system and method of deriving same**

Dezimationssystem mit niedriger Leistung und Verfahren zu seiner Ableitung

Système de décimation à faible consommation et procédé de dérivation dudit système

(84) Designated Contracting States:
**DE FR GB**

(30) Priority: **27.03.2002 US 106549**

(43) Date of publication of application:
**17.12.2003 Bulletin 2003/51**

(73) Proprietor: **Broadcom Corporation**
**Irvine, CA 92617 (US)**

(72) Inventor: **Wang, Minsheng**
**92619 Irvine,**
**California (US)**

(74) Representative: **Jehle, Volker Armin**
**Patentanwälte**
**Bosch, Graf von Stosch, Jehle,**
**Flüggenstrasse 13**
**80639 München (DE)**

(56) References cited:
**US-A- 5 268 905**          **US-B1- 6 233 594**
**US-B1- 6 532 273**

- **KUN LIN ET AL: "Digital filters for high performance audio delta-sigma analog-to-digital and digital-to-analog conversions" SIGNAL PROCESSING, 1996., 3RD INTERNATIONAL CONFERENCE ON BEIJING, CHINA 14-18 OCT. 1996, NEW YORK, NY, USA,IEEE, US, 14 October 1996 (1996-10-14), pages 59-63, XP010209650 ISBN: 0-7803-2912-0**
- **CROCHIERE R E ET AL: "INTERPOLATION AND DECIMATION OF DIGITAL SIGNALS - A TUTORIAL REVIEW" PROCEEDINGS OF THE IEEE, IEEE. NEW YORK, US, vol. 69, no. 3, 1 March 1981 (1981-03-01), pages 300-331, XP000615159 ISSN: 0018-9219**
- **HOGENAUER E B: "AN ECONOMICAL CLASS OF DIGITAL FILTERS FOR DECIMATION AND INTERPOLATION" IEEE TRANSACTIONS ON ACOUSTICS, SPEECH AND SIGNAL PROCESSING, IEEE INC. NEW YORK, US, vol. 29, no. 2, 1 April 1981 (1981-04-01), pages 155-162, XP000560569 ISSN: 0096-3518**

**EP 1 372 264 B1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

*Field of the Invention*

The present invention relates generally to digital filters, and more particularly, to decimation filters.

*Related Art*

A multirate system processes signals at different sample rates, and typically includes one or more sample rate converters for converting between the different sample rates. A sample rate converter often includes a decimation filter. The decimation filter (also referred to as a decimator) receives an input signal having an input sample rate, frequency band-limits the input signal, and downsamples the input signal by a predetermined downsampling factor (also referred to as a decimation factor). Thus, the decimator produces a band-limited output signal having an output sample rate equal to the input sample rate divided by the downsampling factor. The process performed by the decimator is referred to as "decimation filtering," or just "decimation."

A popular type of decimation filter is a Cascaded Integrator-Comb (CIC) filter. The CIC filter is popular because it achieves generally acceptable decimation results while using a relatively simple structure as compared to some other types of conventional decimation filters. The CIC filter can be implemented using digital circuits. Generally, it is desirable that digital circuits consume as little power as possible. This is especially true where such digital circuits are associated with a multirate system constructed on an integrated circuit (IC). Therefore, there is a need for an improved decimation filter that consumes less power than a CIC filter, while achieving a decimation result that is the same as, or at least substantially the same as, that of the CIC filter.

US 6,233,594 is generally directed to a structure for a decimation filter. More specifically, the disclosure includes a method and apparatus for decimating an oversampled signal at the input, which is the output of an oversampling analog-to-digital converter. In accordance with one aspect of the system, an apparatus is provided for decimating an oversampled signal. The apparatus includes at least one non-recursive decimator. Specifically, the at least one non-recursive decimator is configured to receive the oversampled input signal defined by a first sampling frequency. This at least one non-recursive decimator is further configured to generate a output having a second sampling frequency. The apparatus further includes a recursive decimator. The recursive decimator is configured to receive the output of the at least one non-recursive decimator and generate an output having third sampling frequency. It will he appreciated that the second sampling frequency output from the non-recursive decimator is less than the sampling frequency of the oversampled input signal, and further that the third sampling frequency is less that the second sampling frequency. In accordance with another aspect of the disclosure, a method is provided for decimating an oversampled signal. Broadly, the method includes the steps of decimating the oversampled signal in accordance with a non-recursive decimation algorithm to generate an interim decimated signal, and decimating the interim decimated signal in accordance with a recursive decimation algorithm to generate a final decimated signal.

In "Digital Filters for High Performance Audio Delta-sigma Analog-to-digital and Digital-to-analog Conversions" by Kun Lin et al., Signal Processing, 1996, 3rd International Conference in Bejing, China 14-18 Oct. 1996, New York, NY, USA, IEEE, US, 14 October 1996, pages 59-63, XP010209650, ISBN 0-7803-2912-0, there is described a multi-stage decimation filter consisting of comb filters and a single-stage finite impulse response (FIR) filter. A multi-rate comb filter structure is used to reduce the data path width. A multi-stage interpolation filter consists of a half-band filter and a short FIR filter. The short FIR filter is designed with a non-linear phase to realize an overall constant group delay signal path. The coefficients of the FIR filters are quantized to canonical-signed-digit form to realize multiplier-free (shift-and-add) filter implementations.

According to the invention, there is provided a polyphase decimation filter, as defined by independent claim 1, a decimation system, as defined by independent claim 2, a method of performing polyphase filtering, as defined by independent claim 8, and a method of performing decimation, as defined by independent claim 9.

Further advantageous features are specified in dependent claims.

A feature of the present invention is an improved decimation filter/system that consumes less power than a CIC filter, while achieving a decimation result that is the same as, or at least substantially the same as, that of the CIC filter. The improved decimation filter has a modular, repeatable structure, that can be conveniently replicated in a digital, integrated circuit. The improved decimation filter can be used instead of a known CIC filter in a multirate system, thereby reducing power consumption in the multirate system. The improved decimation filter causes downsampling to occur at an early stage in the filter, that is, in an input stage of the filter. Thus, subsequent circuitry operates at a sample rate that is less than the high input sample rate. As a result, less circuitry in the improved decimation filter operates at the high input sample rate as compared to the CIC filter.

*Brief Description Of The Drawings/Figures*

The present invention is described with reference to the accompanying drawings. In the drawings, like reference numbers indicate identical or functionally similar elements.

FIG. 1 is a block diagram of a known CIC filter implemented using digital circuitry.

FIGs. 2A and 2B together represent an illustration of what is referred to as a commutative sampling rule or identity as applied to sample rate conversion (downsampling or up-sampling) and filtering.

FIG. 3A and 3B are diagrammatic illustrations of expansion term reordering that results from commuting expansion terms with downsampling operations in the present invention.

FIG. 4 is a flow chart of an example method of synthesizing a Finite Impulse Response (FIR) decimation system from an $N^{th}$-order CIC filter.

FIG. 5 is a block diagram of an example FIR decimation system.

FIG. 6 is a block diagram of an example FIR filter structure that may be used in the FIR decimation system of FIG. 5.

FIG. 7 is a block diagram of an example polyphase filter that may be used in the system of FIG. 5.

FIG. 8 is a block diagram of another example polyphase filter that may be used in the system of FIG. 5.

FIG. 9 is an illustration of example signal waveforms or timing diagrams for various signals/sequences referenced in FIGs. 7 and 8.

*Detailed Description Of The Invention*

An embodiment of the present invention is a method of deriving a Finite Impulse Response (FIR) decimation system from a known CIC filter. The method relates to certain features of the CIC filter. Therefore, a know CIC filter is described below in detail, and then the method of the present invention is described.

Known CIC Filter

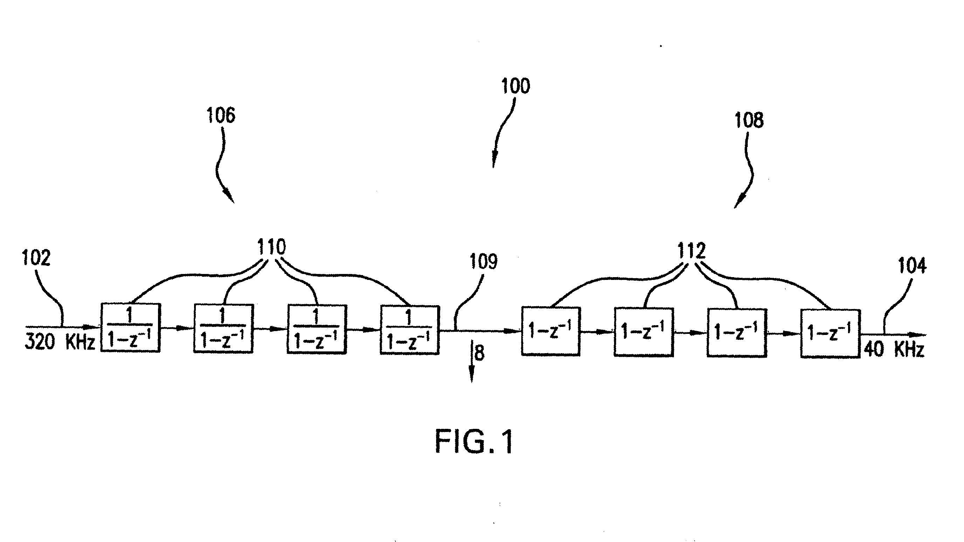

FIG. 1 is a block diagram of a known CIC filter 100 implemented using digital circuitry. CIC filter 100 receives an input signal 102 having an example sample rate of 320 kilohertz (kHz). CIC filter 100 performs decimation filtering of an input signal 102 using a decimation factor of eight (that is, a downsampling factor of eight), to produces a decimated output signal 104 having an example sample rate of 40 kHz (since 40 kHz = 320 kHz divided by eight). In FIG. 1, downsampling by a factor of eight is indicated as "↓8." Downsampling by M (for example, M = 8) causes M-1 out of every M input samples to be dropped in the downsampled output signal.

CIC filter 100 includes an integrator 106 and a filter/downsampler 108 following the integrator. Integrator 106 integrates signal 102, to produce an integrated (and thus, band-limited) intermediate signal 109. Filter/downsampler 108 filters signal 109 and downsamples signal 109 by the decimation factor of eight, to produce decimated output signal 104.

Integrator 106 includes a plurality of cascaded Infinite Impulse Response (IIR) integrator stages 110. "Cascaded" elements (such as filters, integrators, and so on) include elements that are coupled in series with each other such that an output of one element is coupled to an input of a next or successive element.

In the example of FIG. 1, integrator 102 is referred to as a $4^{th}$-order integrator because it includes four integrator stages 110. Moreover, CIC filter 100 is referred to as a $4^{th}$-order CIC filter, for the same reason. Each integrator stage 110 has a filter transfer function H(z) given by

$$H(z) = \frac{1}{1 - z^{-1}}$$

The digital circuitry of integrator 102, including that of each integrator stage 110, operates at a clock rate equal to the input sample rate of 320 kHz. That is, digital circuitry of integrator 102, including flip-flops and registers, for example, is clocked at 320 kHz.

Filter/downsampler 108 includes a plurality of substantially identical cascaded FIR filters 112. Each filter 112 has a filter transfer function H(z) given by

$$H(z) = 1 - z^{-1}$$

Filter/downsampler 106 has a magnitude response approximating that of a highpass filter. Filters 112 add transfer function "zeroes" to offset the transfer function "poles" of integrator 102, and thus add stability to CIC filter 100. Since filter/downsampler 106 downsamples by a factor of eight, much of the digital circuitry of filter/downsampler 106 operates at one-eighth the input sample rate of 320 kHz, that is, at 40 kHz.

Since integrator 106 represents a large portion of the total digital circuitry in CIC filter 100, a large portion of the total digital circuitry operates at the high input clock rate. In one example implementation of CIC filter 100, approximately 9,000 NAND-type logic gates operate at 320 kHz, while approximately 13,000 NAND gates operate at 40 kHz. This is approximately equivalent to 10,600 NAND gates operating at 320 kHz.

From above, it is seen that integrator 102 represents a large portion of the digital circuitry in CIC filter 100. Since digital circuitry consumes more power when operated at a high clock rate than when operated at low clock rate, the integrator consumes a disproportionately large amount of the total power consumed by CIC filter 100. Compared to the CIC filter, the decimation system of the present invention significantly reduces the proportion of digital circuitry operated at the high input sample rate, while achieving decimation results identical to the CIC filter. Thus, the decimation filter of the present invention consumes less total power than does the CIC filter, while achieving identical decimation results.

### Deriving an FIR Decimation System From a CIC Filter

As mentioned above, an aspect of the present invention is a method of deriving an FIR decimation system from a predetermined CIC filter. Below, there is a description of a commutative sampling identity used in the method. Then, there is a description of deriving an example FIR decimation system from CIC filter 100 (described above), using the commutative sampling identity. After this, there is provided a summary or generalized method of deriving an FIR decimation system.

### Commutative Sampling Identity

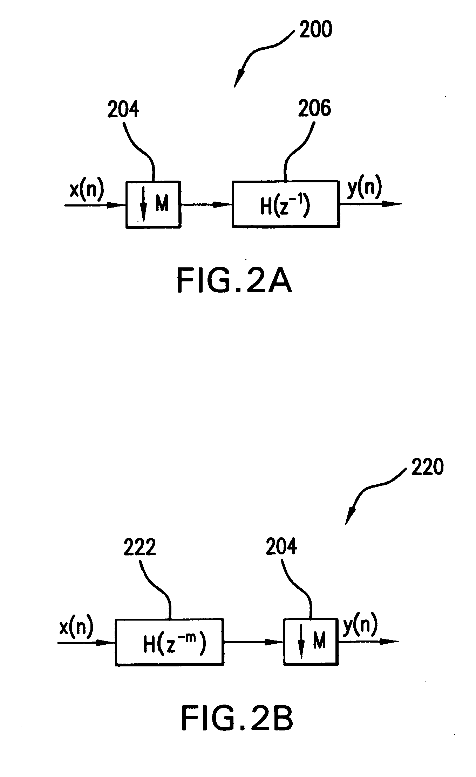

FIGs. 2A and 2B together represent an illustration of what is referred to as the "commutative sampling identity" or just "commutative rule" as applied to sample rate conversion (downsampling or up-sampling) and filtering. FIG. 2A is a block diagram of a sample rate converter 200 including a downsampler 204 followed by a filter 206. Downsampler 204 downsamples an input signal x(n) by a factor M, and then filter 206 filters a downsampled version of the input signal according to the transfer function $H(z^{-1})$. Filter 206 produces an output signal y(n). The operation of converter 200 can be represented by the expression "$\downarrow M\ H(z^{-1})$," where the symbol "$\downarrow$" represents the downsampling operation, and $\downarrow M$ represents downsampling by a factor of M (that is, using a decimation factor of M).

FIG. 2B is a block diagram of a sample rate converter 220 that is functionally equivalent to converter 200 because of the commutative rule mentioned above. Equivalent converter 220 reverses the order of downsampling and filtering compared to converter 200. That is, converter 220 includes a filter 222 followed by downsampler 206. Filter 222 has a transfer function $H(z^{-M})$, instead of the transfer function $H(z^{-1})$ of filter 206. The operation of converter 220 can be represented by the expression "$H(z^{-M})$, followed by $\downarrow M$," or more simply, as $H(z^{-M})\ \downarrow M$. Equivalent converter 220 achieves the same results as converter 200. In other words, $H(z^{-M})\ \downarrow M \equiv \downarrow M\ H(z^{-1})$. Thus, the operations of filtering and downsampling can be interchanged, that is, commuted, as illustrated in FIGs. 2A and 2B.

### Deriving an Example FIR Decimation System

CIC filter 100 of FIG. 1 has a transfer function $H(z)_{CIC}$ represented by:

$$H(z)_{CIC} = \left[ \frac{1 - z^{-8}}{1 - z^{-1}} \right]^4 \downarrow 8 \qquad \text{Eq. (1)}$$

Since downsampling represents a non-linear process, Eq. (1) is not a strict mathematical representation of the transfer function of CIC filter 100. Rather, Eq. (1) is provided for illustrative purposes.

A first step in deriving the example FIR decimation system includes expanding the transfer function $H(z)_{CIC}$ into a series of expansion terms, including a first expansion term $\frac{1 - z^{-8}}{1 - z^{-4}}$, a second expansion term $\frac{1 - z^{-4}}{1 - z^{-2}}$, and a third expansion term $\dfrac{1-z^{-2}}{1-z^{-1}}$, as follows:

$$H(z)_{CIC} = \left[ \frac{1-z^{-8}}{1-z^{-4}} \frac{1-z^{-4}}{1-z^{-2}} \frac{1-z^{-2}}{1-z^{-1}} \right]^4 \downarrow 8 \qquad \text{Eq. (2)}$$

It can be seen in Eq. (2) that

> (i) the first term denominator and the second term numerator cancel one another, and
> (ii) the second term denominator and the third term numerator cancel one another.

Thus, Eq. (2) can be reduced to Eq. (1) by canceling numerator and denominator terms.
Since $\downarrow 8 = \downarrow 4 \downarrow 2$, then Eq. (2) can be re-written as

$$H(z)_{CIC} = \left[ \frac{1-z^{-8}}{1-z^{-4}} \frac{1-z^{-4}}{1-z^{-2}} \frac{1-z^{-2}}{1-z^{-1}} \right]^4 \downarrow 4 \downarrow 2 \qquad \text{Eq. (3)}$$

This can be considered a downsampling factoring step, since $\downarrow 8$ is factored into $\downarrow 4$ and $\downarrow 2$. In Eq. (3), each of the first two expansion terms, when followed by the downsampling operation $\downarrow 4$, can be considered to have the general form $H(z^{-M}) \downarrow M$, as discussed above in connection with FIG. 2B. For example, the first expansion term $\dfrac{1-z^{-8}}{1-z^{-4}}$, followed by $\downarrow 4$, can be generalized as $\dfrac{1-z^{-2M}}{1-z^{-1M}}$, followed by $\downarrow M$, where M = 4.

A next step in deriving the example FIR decimation system is an iterative step. This step includes applying the commutative rule to Eq. (3). Specifically, in Eq. (3), the first expansion term $\dfrac{1-z^{-8}}{1-z^{-4}}$ and $\downarrow 4$ are commuted (reversed) to a corresponding commuted expression $\downarrow 4 \left[ \dfrac{1-z^{-2}}{1-z^{-1}} \right]^4$. This commuted expression has the form $\downarrow M\, H(z^{-1})$ of FIG. 2A, where M = 4. When the first expansion term of Eq. (3) is replaced with its corresponding commuted expression, Eq. (3) becomes

$$H(z)_{CIC} = \left[ \frac{1-z^{-4}}{1-z^{-2}} \frac{1-z^{-2}}{1-z^{-1}} \right]^4 \downarrow 4 \left[ \frac{1-z^{-2}}{1-z^{-1}} \right]^4 \downarrow 2 \qquad \text{Eq. (4)}$$

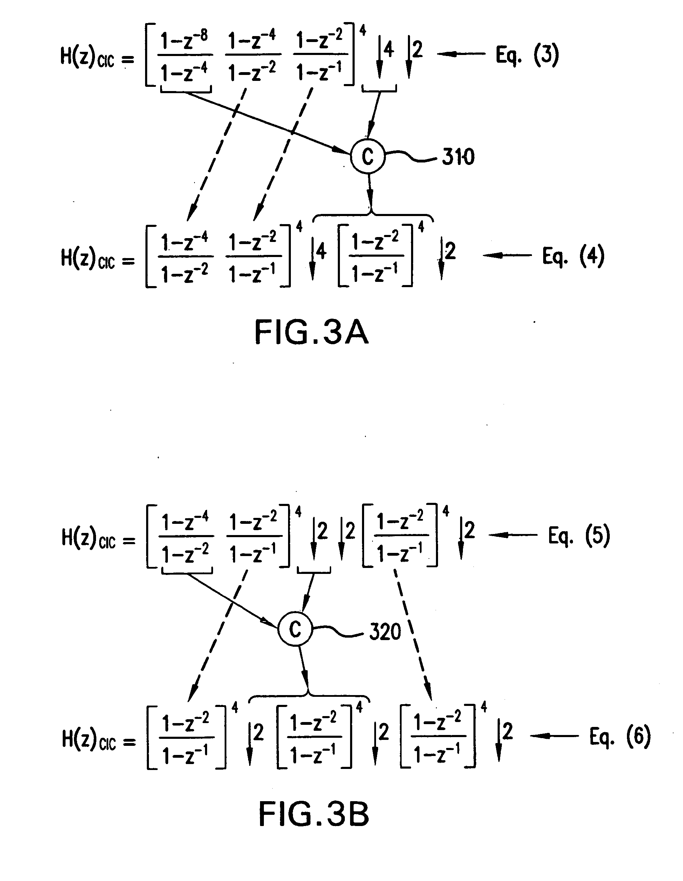

Commuting the first term of Eq. (3) in the manner described above causes the second and third expansion terms of Eq. (3) to become the first and second expansion terms in Eq. (4), respectively. This expansion term reordering is depicted in FIG. 3A. FIG. 3A is a diagrammatic illustration of the expansion term reordering between Eqs. (3) and (4) that is caused as a result of commuting the first expansion term in Eq. 3 with $\downarrow 4$. In FIG. 3A, the commuting operation is indicated at 310.
Since $\downarrow 4 = \downarrow 2 \downarrow 2$, Eq. (4) can be re-written as

$$H(z)_{CIC} = \left[\frac{1-z^{-4}}{1-z^{-2}}\frac{1-z^{-2}}{1-z^{-1}}\right]^4 \downarrow 2 \downarrow 2 \left[\frac{1-z^{-2}}{1-z^{-1}}\right]^4 \downarrow 2 \qquad \text{Eq. (5)}$$

This represents another factoring step. In Eq. (5), the first expansion term $\frac{1-z^{-4}}{1-z^{-2}}$, followed by $\downarrow 2$, can be re-written as $\frac{1-z^{-2M}}{1-z^{-1M}} \downarrow M$, where M = 2. The commutative rule is now applied again, this time, to Eq. (5). Specifically, the first expansion term in Eq. (5), namely, the expansion term $\frac{1-z^{-4}}{1-z^{-2}}$, is commuted with $\downarrow 2$ (that is, M = 2 in this iteration). Therefore, the expression $\frac{1-z^{-4}}{1-z^{-2}} \downarrow 2$ commutes to a corresponding commuted expression $\downarrow 2 \frac{1-z^{-2}}{1-z^{-1}}$. When the first expansion term in Eq. (5) is replaced with its corresponding commuted expression, Eq. (5) becomes

$$H(z)_{CIC} = \left[\frac{1-z^{-2}}{1-z^{-1}}\right]^4 \downarrow 2 \left[\frac{1-z^{-2}}{1-z^{-1}}\right]^4 \downarrow 2 \left[\frac{1-z^{-2}}{1-z^{-1}}\right]^4 \downarrow 2 \qquad \text{Eq. (6)}$$

FIG. 3B is a diagrammatic illustration of the expansion term reordering between Eqs. (5) and (6) that is caused as a result of commuting the first expansion term in Eq. 5 with $\downarrow 2$. In FIG. 3B, the commuting operation is indicated at 320.

A final step includes using a polynomial expansion to reduce each term $\left[\frac{1-z^{-2}}{1-z^{-1}}\right]^4$ ] in Eq. (6) to the form $(1+4z^{-1}+6z^{-2}+4z^{-3}+z^{-4})$. Therefore, Eq. (6) reduces to Eq. (7), below

$$H(z)_{CIC} = (1+4z^{-1}+6Z^{-2}+4z^{-3}+z^{-4}) \downarrow 2 \ (1+4z^{-1}+6Z^{-2}+4z^{-3}+z^{-4}) \downarrow 2 \ (1+4z^{-1}+6Z^{-2}+4z^{-3}+z^{-4}) \downarrow 2$$

In Eq. (7), each term $(1+4z^{-1}+6z^{-2}+4z^{-3}+z^{-4})$ represents an FIR filter transfer function $H(z)_{FIR}$. Thus, Eq. (7) becomes

$$H(z)_{CIC} = H(z)_{FIR} \downarrow 2 \ H(z)_{FIR} \downarrow 2 \ H(z)_{FIR} \downarrow 2 \qquad \text{Eq. (8)}$$

Eqs. (7) and (8) represent the example FIR decimation system derived from CIC filter 100. Eq. (8) can be realized as three, substantially identical, cascaded FIR decimation filters, each of the FIR filters causing downsampling by a factor of two, and having the transfer function

$$H(z)_{FIR} = (1+4z^{-1}+6z^{-2}+4z^{-3}+z^{-4}) = (1 + z^{-1})^4 \qquad \text{Eq. (9)}$$

From Eq. (9), it is seen that the FIR filter coefficients are the polynomial coefficients produced in the polynomial expansion of $(1 + z^{-1})^4$.

According to the above example, a 4th-order CIC filter ($H(z)_{CIC}$) that performs decimation by a factor of eight (8) (where $8 = 2^3$), can be implemented as three substantially identical cascaded FIR decimation filters. Each FIR decimation filter has a transfer function $H(z)_{FIR} = (1 + z^{-1})^4$, and performs decimation by a factor of two. More generally, an $N^{th}$-order CIC filter that performs decimation by a factor $I^L$, can be implemented as a plurality, L, of cascaded FIR decimation filters, where each FIR decimation filter has a transfer function $(1 + z^{-1})^N$, and performs decimation by a factor I.

Summary Method

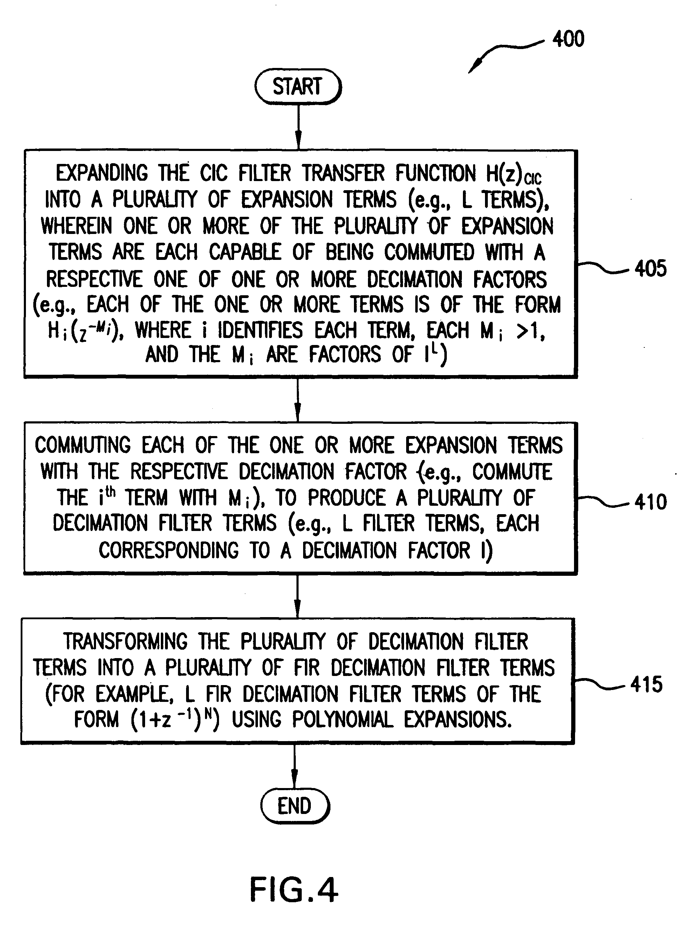

FIG. 4 is a flow chart of an example method 400 of synthesizing an FIR decimation system from an $N^{th}$-order CIC filter (represented as a transfer function $H(z)_{CIC}$) that performs decimation by a factor $I^L$. The FIR decimation system is identical to the CIC filter $H(z)_{CIC}$. That is, the FIR decimation system and the CIC filter achieve identical decimation results.

A first step 405 includes expanding the CIC filter transfer function $H(z)_{CIC}$ into a plurality of expansion terms (for example, into L terms). Each of one or more of the plurality of expansion terms is capable of being commuted with a respective one of one or more decimation factors. For example, step 405 includes expanding $H(z)_{CIC}$ into one or more terms of the form $H_i(z^{-M_i})$, where i identifies each of the one or more terms, and each $M_i$ is a factor of $I^L$ that is greater than one, such that a product of all of the $M_i$ is equal to $I^L$.

Therefore, step 405 can be considered to include a first sub-step of factoring $I^L$ into one or more factors $M_i$, and a second sub-step of deriving the one or more expansion terms such that each term has the form $H_i(z^{-M_i})$.

A next step 410 is an iterative step that includes commuting each of the one or more expansion terms with the respective decimation factor, to produce a plurality of decimation filter terms. For example, step 410 includes commuting each term $H_i(z^{-M_i})$ with $\downarrow M$. Steps 405 and 410 produce L filter terms, each corresponding to a decimation factor I.

A next step 415 includes transforming the plurality of decimation filter terms into a plurality of FIR decimation filter terms. For example, this step produces L FIR decimation filter terms of the form $(1+z^{-1})^N$ using polynomial expansions, where each of the FIR decimation filter terms corresponds to decimation by a factor I.

***FIR Decimation System***

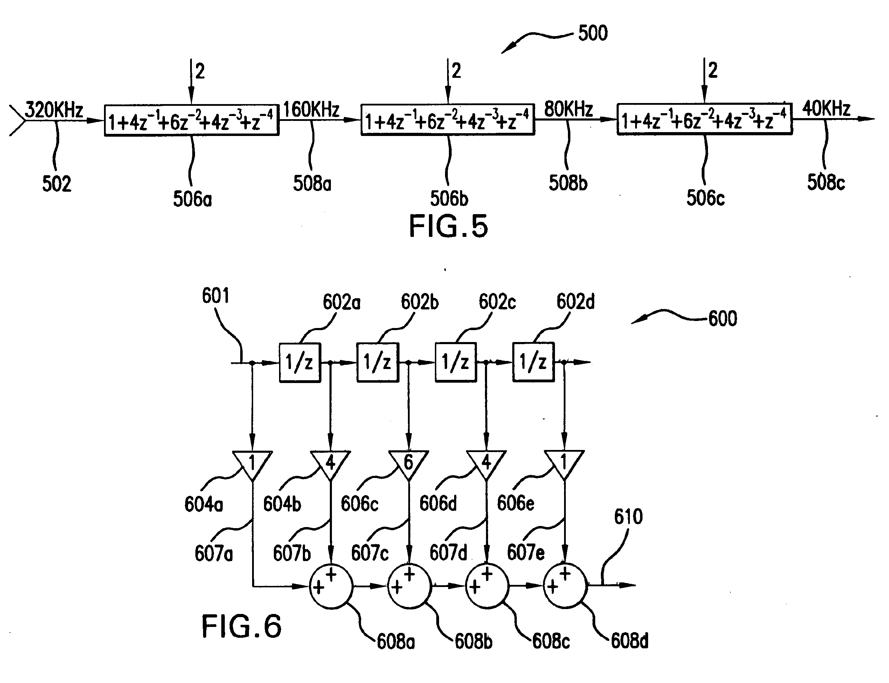

FIG. 5 is a block diagram of an example FIR decimation system 500 corresponding to Eq. (7) and (8). FIG decimation system 500 achieves decimation results identical, or at least substantially identical, to those achieved using CIC filter 100. System 500 includes a plurality of cascaded FIR decimation filters 506a, 506b and 506c. Each of the FIR decimation filters 506a-c performs decimation by a factor of two. Also, each of the decimation filters 506a-c has a transfer function $H(z)_{FIR} = (1+z^{-1})^4$. In operation, the first FIR decimation filter 506a receives an input signal 502, having an input sample rate R (where R = 320 kHz, for example). Filter 506a filters and downsamples-by-two input signal 502, to produce a decimated output signal 508a at a sample rate R/2 (where R/2 = 160 kHz, for example). The next filter 506b filters signal 508a and downsamples the signal by a factor of two, to produce a decimated signal 508b at a sample rate R/4 (where R/4 = 80 kHz, for example). Similarly, filter 506c filters and downsamples-by-two signal 508b, to produce a decimated output signal 508c at a sample rate R/8 (where R/8 = 40 kHz, for example).

FIG. 6 is a block diagram of an example FIR filter structure 600 that may be used in each of FIR filters 506a-c. Structure 600 represents a transversal FIR filter structure. Filter structure 600 includes a plurality of cascaded unit delays 602a-602d to successively delay an input signal 601. Structure 600 also includes a plurality of gain stages 604a, 604b, 604c, 604d, and 604e to apply respective weights of "1," "4," "6," "4," and "1" to input signal 601 and the successively delayed versions thereof produced by unit delays 602a, 602b, 602c and 602d, as depicted in FIG. 6. In FIG. 6, the weights "1," "4," and so on, applied by each gain stage 604a, 604b, and so on, are depicted inside the triangular gain stage symbols. These weights represent FIR filter coefficients corresponding to the transfer function $(1+z^{-1})^4$. Gain stages 604a-e provide respective weighted signals 607a-e to cascaded combiners 608a-d, as depicted in FIG. 6. The last combiner 608d produces a decimated output signal 610. Filter structure 600 may perform decimation by a factor of two by "dropping" every other output sample in signal 610, as would be apparent to one of ordinary skill in the relevant arts.

Polyphase Decimation Filters

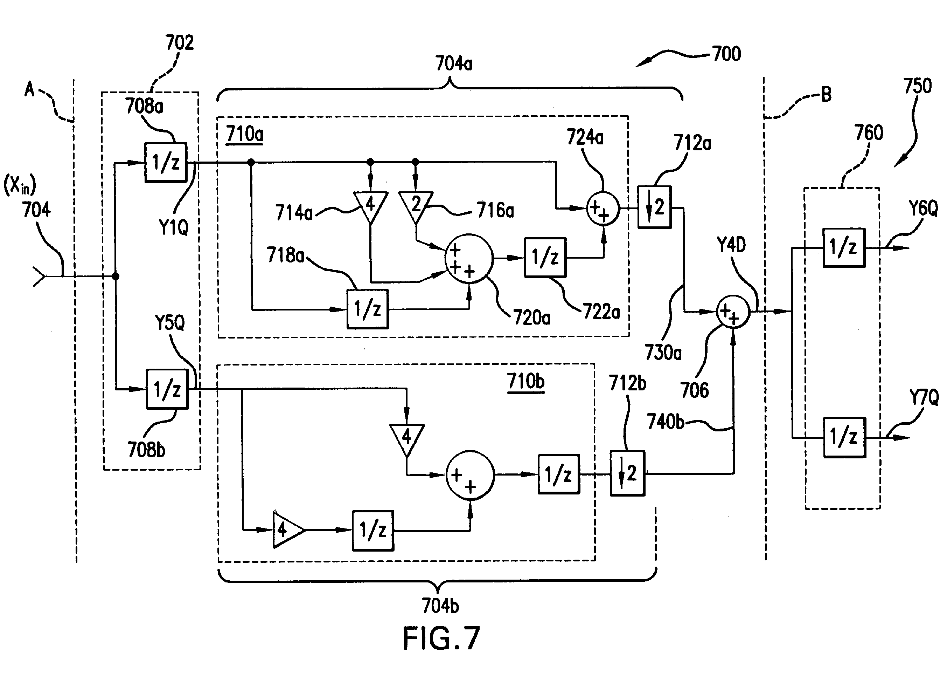

Referring again to FIG. 5, each of the cascaded decimation filters 506a-c may include a polyphase filter, whereby decimation system 500 includes a plurality of cascaded polyphase filters. FIG. 7 is a block diagram of an example polyphase filter 700 that may be used in each decimation stage 506a-c. Polyphase filter 700 includes all of the elements depicted between spaced, vertical dashed lines A and B. Polyphase filter 700 includes an input stage 702, and a plurality of parallel FIR decimation stages 704a and 704b each coupled to a respective output of input stage 702. Filter 700 also includes a combiner 706 coupled to respective outputs of the plurality of decimation stages 704a and 704b.

Input stage 702 receives an input signal 704. For example, if signal 704 represents signal 502, 508a or 508b in FIG. 5, then filter 700 represents filter 500a, 500b, or 500c, respectively. Input signal 704 may be represented as a sampled sequence including samples $x_1$, $x_2$, $x_3$, $x_4$, $x_5$, $x_6$ ..., having an input sample rate R (where R = 320 kHz, for example). Input stage 702 includes unit delays/samplers 708a and 708b to respectively sub-sample input signal 704, to produce respective sub-sampled signals Y1Q and Y5Q having respective sample rates R/2. For example, sequence Y1Q includes samples $x_1$, $x_3$, $x_5$ ...., while sequence Y5Q includes alternate samples $x_2$, $x_4$, $x_6$ .... Substantially all of the digital circuitry associated with filter 700, including input stage 702, is clocked at a clock rate equal to the sample rate of sequences Y1Q and Y5Q, namely, at a clock rate R/2. Sub-sampled signals Y1Q and Y5Q are time-shifted with respect to each other.

Input stage 702 provides sequences Y1Q and Y5Q to respective parallel decimation stages 704a and 704b. Decimation stage 704a includes an FIR filter 710a followed by a downsampler 712a that downsamples by a factor of two. Similarly, decimation stage 704b includes an FIR filter 710b followed by downsampler 712b. FIR filter 710a includes first and second gain stages 714a and 716a for applying gains or weights to sequence Y1Q. Filter 710a includes a unit delay 718a for delaying sequence Y1Q. The respective outputs of gain stages 714a and 716a and unit delay 718a are each coupled to respective inputs of a combiner/adder 720a for combining signals produced by the gain stages and the unit delay. Combiner 720a provides a combined signal to a unit delay 722a. Unit delay 722a provides a delayed combined signal to an output combiner 724a, which combines sequence Y1Q with the delayed combined signal 722a.

Combiner 724a provides a filtered signal to downsampler 712a. Downsampler 712a provides a decimated output signal component 730a to combiner 706. Filter 710b provides a filtered signal to downsampler 712b. Downsampler 712b provides a decimated output signal component 740b to combiner 706. Combiner 706 combines decimated output signal components 730a and 740b to produce decimated output signal Y4D (which may be one of signals 508a, 508b, and 508c in FIG. 5, for example). Output signal Y4D has a sample rate R/2.

If filter 700 is not the last cascaded filter (such as last filter 500c in FIG. 5), then filter 700 provides decimated output signal Y4D to a next cascaded filter 750. Only a portion of filter 750, namely an input stage 760, is depicted in FIG. 7. Input stage 760 is substantially identical to input stage 702, described above. Input stage 760 operates at a clock rate R/4 (where R/4 = 80 kHz, for example), and produces each of sub-sampled sequences Y6Q and Y7Q at the sample rate R/4. Substantially all of the digital circuitry of filter 750 is clocked at a clock rate R/4.

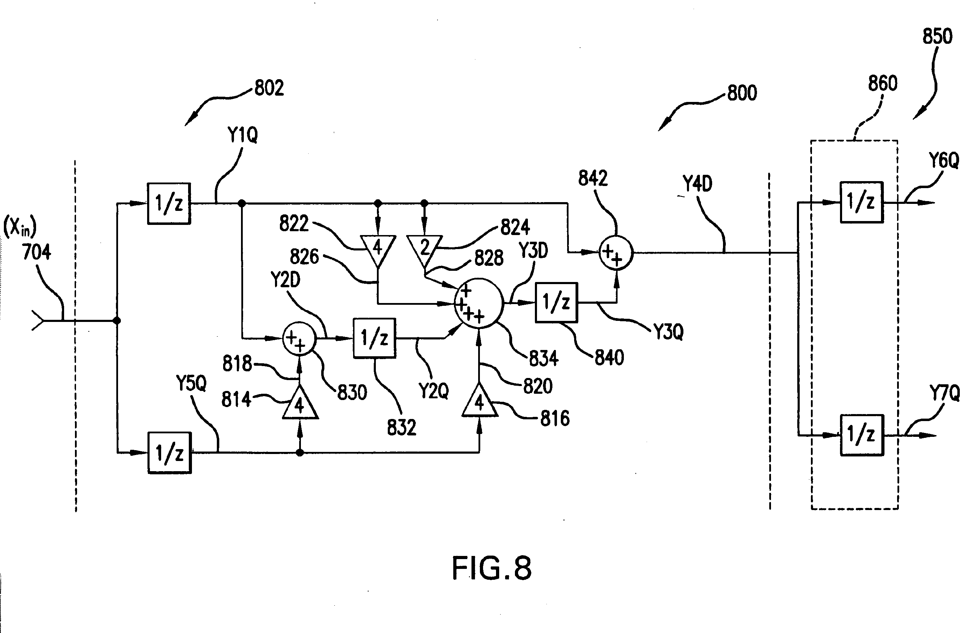

FIG. 8 is a block diagram of a polyphase filter 800, according to an alternative embodiment of the present invention. Filter 800 uses less circuit elements (for example, logic gates) and thus less power than does filter 700, but achieves the same decimation results as filter 700. The elements of filter 800, described below, are clocked at the clock rate R/2.

Filter 800 includes an input stage 802 that is substantially identical to input stage 702 described above in connection with FIG. 7. Filter 800 includes first and second gain stages 814 and 816, to respectively apply first and second weights to signal Y5Q, to produce respective weighted signals 818 and 820. Filter 800 includes third and fourth gain stages 822 and 824 to apply respective third and fourth weights to signal Y1Q, to produce respective weighted signals 826 and 828. Filter 800 includes a first combiner 830 for combining signal Y1Q with signal 818, to produce a combined signal Y2D. Filter 800 includes a unit delay 832 to produce a delayed signal Y2Q from signal Y2D. A combiner 834 combines signals Y2Q, 826, 828 and 820 to produce a combined signal Y3D. A delay 840 delays signal Y3D to produce delayed signal Y3Q. A combiner 842 combines signals Y3Q with Y1Q to produce the combined signal Y4D.

Filter 800 provides signal Y4D to a next cascaded filter 850 (assuming filter 800 is not the last cascaded filter). Only an input portion 860 of filter 850 is depicted in FIG. 8. Filter 850 operates at a clock rate R/4.

In an embodiment where each of the filters 500a-c of system 500 are implemented using the structure of filter 800, approximately 1500 NAND gates (that is, logic gates) are clocked at the rate R (for example, 320 kHz), 4200 logic gates are clocked at the rate R/2 (for example, 160 kHz), 5100 logic gates are clocked at the rate R/4 (for example, 80 kHz), and 3300 logic gates are clocked at the rate R/8 (for example, 40 kHz). This approximates to 5300 logic gates being clocked at the rate R. Therefore, in this embodiment, a much smaller proportion of the digital circuitry in system 500 operates at the high input clock rate as compared to CIC filter 100 (which has approximately 9000 logic gates clocked at the rate R). Therefore, this embodiment consumes only a half the power that CIC filter 100 consumes, yet achieves decimation results identical, or at least substantially identical, to that of CIC filter 100. The present invention is not limited to the above-mentioned example number of logic gates. Alternative numbers of logic gates can be used.

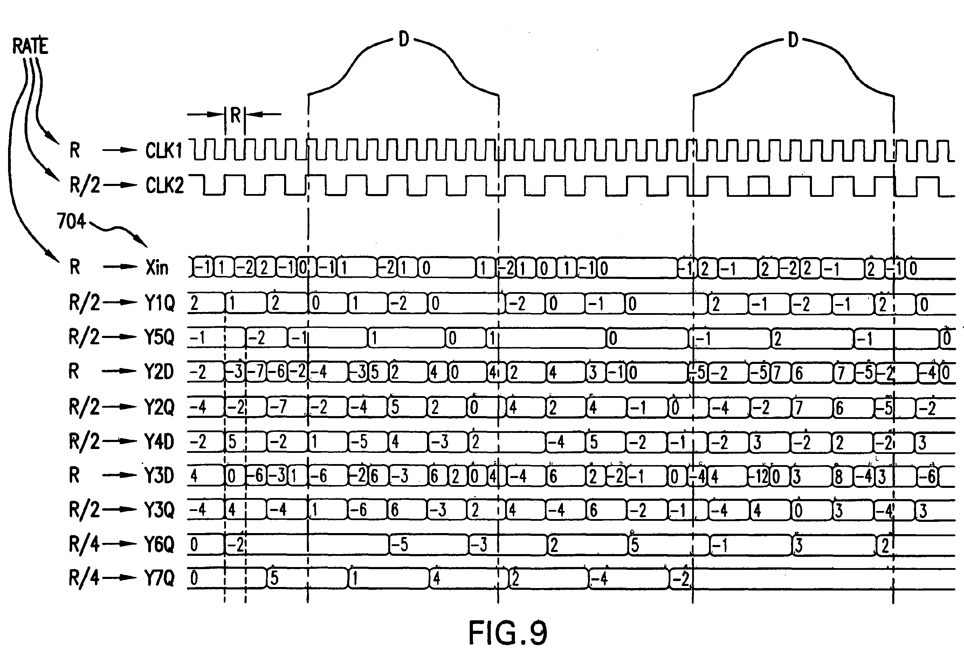

FIG. 9 is an illustration of example signal waveforms or timing diagrams for various signals/sequences referenced in FIGs. 7 and 8. The timing relationships between the various example waveforms are also depicted in FIG. 9. For example, vertical spaced lines D indicated timing relationships between various ones of the waveforms depicted in FIG. 9. Waveforms CLK1 and CLK2 represent example clock signals that are used to clock logic gates in filters 700 and 800. Also indicated in FIG. 9 are the sample/clock rates (for example, R, R/2, and so on) of the various waveforms.

Also, example data values associated with the various signals, are indicated in FIG. 9. For example, signal 704 (Xin) includes successive data samples having data values -1, 1, -2, 2, -1, 0, and so on, traversing the waveform from left-to-right in FIG. 9. Signals Y1Q and Y5Q are sub-sampled sequences having data sample values taken alternately from signal Xin.

**Claims**

1. A polyphase decimation filter (800), comprising:

   an input stage (802) for generating, from an input signal (704) , a first sub-sampled signal (Y5Q) and a second sub-sampled signal (Y1Q);
   first and second gain stages (814,816) for applying respective first and second weights to the first sub-sampled signal (Y5Q), to produce respective first and second weighted signals (818,820);
   third and fourth gain stages (822,824) for applying respective third and fourth weights to the second sub-sampled signal (Y1Q), to produce respective third and fourth weighted signals (826,828);
   a first combiner (830) for combining
   the second signal (Y1Q), and
   the first weighted signal (818), to produce a first combined signal (Y2D);
   a first unit delay (832) for producing a delayed first combined signal (Y2Q);
   a second combiner (834) for combining
   the delayed first combined signal (Y2Q),
   the second weighted signal (820),
   the third weighted signal (826), and
   the fourth weighted signal (828), to produce a second combined signal (Y3D);
   a second unit delay (840) for producing a delayed second combined signal (Y3Q); and
   a third combiner (842) for combining
   the delayed second combined signal (Y3Q), and
   the second signal (Y1Q), to produce a decimated output signal (Y4D).

2. A decimation system (500), comprising:

   a plurality of cascaded Finite Impulse Response (FIR) decimation filters (506a-c,700,800), each having a transfer function $H(z) = (1+z^{-1})^N$, where N is an integer,

   wherein each of at least two of the plurality of cascaded FIR decimation filters (506a-c,700,800) includes a polyphase FIR filter (700,800),
   **characterised in that** at least one of the polyphase filters (700,800) is
   the polyphase decimation filter (800) of claim 1.

3. The decimation system (500) of claim 2, wherein the polyphase decimation filter (800) of claim 1 comprises:

   the input stage (802) having an input, a first output, and a second output;
   the first and second gain stages (814,816) having their respective inputs coupled to the first output of the input stage (802);
   the third and fourth gain stages (822,824) having their respective inputs coupled to the second output of the input stage;
   the first combiner (830) having respective inputs coupled to the second output of the input stage (802), and an output of the first gain stage (814);
   the first unit delay (832) having an input coupled to an output of the first combiner (830);
   the second combiner (834) having respective inputs coupled to
   an output of the first unit delay (832),
   an output of the second gain stage (816),
   an output of the third gain stage (822),
   an output of the fourth gain stage (824); and
   the second unit delay (840) having an input coupled to an output of the second combiner (834); and
   the third combiner (842) having respective inputs coupled to
   an output of the second unit delay (840), and
   the second output of the input stage (802).

4. The system (500) of claim 2, wherein each of the FIR decimation filters (506a-c,700,800) is configured to perform decimation by a common decimation factor I.

5. The system (500) of claim 2, wherein each of the polyphase filters (700,800) has the transfer function H(z).

**6.** The system (500) of claim 2, wherein each of the polyphase filters (700,800) is configured to receive a respective input signal, at least one of the polyphase filters (700) comprising:

an input stage (702) that generates a plurality of sub-sampled signals (Y1Q,Y5Q) from the respective input signal (502,704);
a plurality of parallel FIR decimation stages (704a,704b), each of the parallel FIR decimation stages (704a, 704b) for producing a respective decimated output signal component (730a,730b) from a respective one of the plurality of sub-sampled signals (Y1Q,Y5Q); and
a signal combiner (706) for combining the plurality of decimated output signal components (730a,730b) produced by the plurality of decimation stages (704a,704b), whereby the combiner (706) produces a decimated output signal (Y4D,508a-c).

**7.** The system (500) of claim 6, wherein each of the parallel FIR decimation stages(704a,704b) includes:

an FIR filter (710a,710b); and
a downsampler (712a,712b) following the FIR filter (710a,710b).

**8.** A method of performing polyphase filtering, comprising:

generating, from an input signal (704), a first sub-sampled signal (Y5Q) and a second sub-sampled signal (Y1Q);
applying first and second weights to the first sub-sampled signal (Y5Q) to produce respective first and second weighted signals (818,820) ;
applying third and fourth weights to the second sub-sampled signal (Y1Q) to produce respective third and fourth weighted signals (826,828);
combining
the second signal (Y1Q), and
the first weighted signal (818), to produce a first combined signal (Y2D);
producing a delayed first combined signal (Y2Q);
combining
the delayed first combined signal (Y2Q),
the second weighted signal (820),
the third weighted signal (826), and
the fourth weighted signal (828), to produce a second combined signal (Y3D);
producing a delayed second combined signal (Y3Q); and
combining
the delayed second combined signal (Y3Q), and
the second signal (Y1Q), to produce a decimated output signal (Y4D).

**9.** A method of performing decimation, comprising:

(a) performing successive stages of Finite Impulse Response (FIR) decimation filtering, each of the stages of FIR decimation filtering using a transfer function $H(z) = (1+z^{-1})^N$, where N is an integer,

**characterised in that** each of at least two of the successive stages of FIR decimation filtering includes polyphase filtering of the method of claim 8.

**10.** The method of claim 9, wherein each of the successive stages of FIR decimation filtering causes decimation by a decimation factor I, whereby step (a) causes decimation by a decimation factor $I^L$.

**11.** The method of claim 9, wherein said step of polyphase filtering includes polyphase FIR filtering using the transfer function H(z).

**12.** The method of claim 9, wherein said step of polyphase filtering includes:

generating a plurality of sub-sampled signals (Y1Q) from an input signal;
producing, in parallel, a decimated output signal component (730a,730b) from at least two of the plurality of sub-sampled signals (Y1Q,Y5Q); and
combining the plurality of decimated output signal components (730a,730), to produce a decimated output signal (Y4D).

**13.** The method of claim 12, wherein said producing step comprises:

separately FIR filtering each of the sub-sampled signals to produce respective FIR filtered signals; and downsampling each of the FIR filtered signals, to produce the decimated output signal components.

**Patentansprüche**

**1.** Mehrphasen-Dezimierungsfilter (800), das Folgendes umfasst:

eine Eingangsstufe (802) zum Erzeugen aus einem Eingangssignal (704) eines ersten unterabgetasteten Signals (Y5Q) und eines zweiten unterabgetasteten Signals (Y1Q);
erste und zweite Verstärkungsstufen (814, 816) zum Anlegen jeweiliger erster und zweiter Gewichtungen an das erste unterabgetastete Signal (Y5Q), um jeweilige erste und zweite gewichtete Signale (818, 820) zu erzeugen;
dritte und vierte Verstärkungsstufen (822, 824) zum Anlegen jeweiliger dritter und vierter Gewichtungen an das zweite unterabgetastete Signal (Y1Q), um jeweilige dritte und vierte gewichtete Signale (826, 828) zu erzeugen;
einen ersten Kombinator (830) zum Kombinieren
des zweiten Signals (Y1Q) und
des ersten gewichteten Signals (818), um ein erstes kombiniertes Signal (Y2D) zu erzeugen;
eine erste Einheitsverzögerung (Unit Delay) (832) zum Erzeugen eines verzögerten ersten kombinierten Signals (Y2Q);
einen zweiten Kombinator (834) zum Kombinieren
des verzögerten ersten kombinierten Signals (Y2Q),
des zweiten gewichteten Signals (820),
des dritten gewichteten Signals (826) und
des vierten gewichteten Signals (828), um ein zweites kombiniertes
Signal (Y3D) zu erzeugen;
eine zweite Einheitsverzögerung (840) zum Erzeugen eines verzögerten zweiten kombinierten Signals (Y3Q); und
einen dritten Kombinator (842) zum Kombinieren
des verzögerten zweiten kombinierten Signals (Y3Q) und
des zweiten Signals (Y1Q), um ein dezimiertes Ausgangssignal (Y4D) zu erzeugen.

**2.** Dezimierungssystem (500), das Folgendes umfasst:

eine Vielzahl von kaskadierten endlichen Impulsantwort- (FIR; Finite Impulse Response) -Dezimierungsfiltern (506a-c, 700, 800), die jedes eine Übertragungsfunktion $H(z) = (1+z^{-1})^N$ aufweisen, wobei N eine ganze Zahl ist,

wobei jedes von wenigstens zwei der Vielzahl von kaskadierten FIR-Dezimierungsfiltern (506a-c, 700, 800) ein Mehrphasen-FIR-Filter (700, 800) umfasst,
**dadurch gekennzeichnet, dass** wenigstens eines der Mehrphasenfilter (700, 800) der Mehrphasen-Dezimierungsfilter (800) nach Anspruch 1 ist.

**3.** Dezimierungssystem (500) nach Anspruch 2, wobei das Mehrphasen-Dezimierungsfilter (800) nach Anspruch 1 Folgendes umfasst:

die Eingangsstufe (802), die einen Eingang, einen ersten Ausgang und
einen zweiten Ausgang aufweist;
die ersten und zweiten Verstärkungsstufen (814, 816), deren jeweilige Eingänge mit dem ersten Ausgang der Eingangsstufe (802) gekoppelt sind;
die dritten und vierten Verstärkungsstufen (822, 824), deren jeweilige Eingänge mit dem zweiten Ausgang der Eingangsstufe gekoppelt sind; den ersten Kombinator (830), der jeweilige Eingänge aufweist, die mit dem zweiten Ausgang der Eingangsstufe (802) und einem Ausgang der ersten Verstärkungsstufe (814) gekoppelt sind;
die erste Einheitsverzögerung (832), die einen Eingang aufweist, der mit einem Ausgang des ersten Kombinators (830) gekoppelt ist;

den zweiten Kombinator (834), der jeweilige Eingänge aufweist, die mit

einem Ausgang der ersten Einheitsverzögerung (832),

einem Ausgang der zweiten Verstärkungsstufe (816),

einem Ausgang der dritten Verstärkungsstufe (822),

einem Ausgang der vierten Verstärkungsstufe (824) gekoppelt sind;

und

die zweite Einheitsverzögerung (840), die einen Eingang aufweist, der mit einem Ausgang des zweiten Kombinators (834) gekoppelt ist; und

den dritten Kombinator (842), der jeweilige Eingänge aufweist, die mit

einem Ausgang der zweiten Einheitsverzögerung (840) und

dem zweiten Ausgang der Eingangsstufe (802) gekoppelt sind.

**4.** System (500) nach Anspruch 2, wobei jedes der FIR-Dezimierungsfilter (506a-c, 700, 800) so konfiguriert ist, dass es eine Dezimierung um einen gemeinsamen Dezimierungsfaktor I durchführt.

**5.** System (500) nach Anspruch 2, wobei jedes der Mehrphasenfilter (700, 800) die Übertragungsfunktion H(z) aufweist.

**6.** System (500) nach Anspruch 2, wobei jedes der Mehrphasenfilter (700, 800) so konfiguriert ist, dass es ein jeweiliges Eingangssignal empfängt,

wobei wenigstens eines der Mehrphasenfilter (700) Folgendes umfasst:

eine Eingangsstufe (702), die eine Vielzahl von unterabgetasteten Signalen (Y1 Q, Y5Q) aus dem jeweiligen Eingangssignal (502, 704) generiert;

eine Vielzahl von parallelen FIR-Dezimierungsstufen (704a, 704b), wobei jede der parallelen FIR-Dezimierungsstufen (704a, 704b) für die Erzeugung einer jeweiligen dezimierten Ausgangssignal-Komponente (730a, 730b) aus einem jeweiligen einen der Vielzahl von unterabgetasteten Signalen (Y1Q, Y5Q) bestimmt ist; und

einen Signalkombinator (706) zum Kombinieren der Vielzahl von dezimierten Ausgangssignal-Komponenten (730a, 730b), die durch die Vielzahl von Dezimierungsstufen (704a, 704b) erzeugt wurden, wodurch der Kombinator (706) ein dezimiertes Ausgangssignal (Y4D, 508a-c) erzeugt.

**7.** System (500) nach Anspruch 6, wobei jede der parallelen FIR-Dezimierungsstufen (704a, 704b) Folgendes enthält:

ein FIR-Filter (710a, 710b); und

einen Abwärtsabtaster (712a, 712b) im Anschluss an das FIR-Filter (710a, 710b).

**8.** Verfahren zur Durchführung einer Mehrphasenfilterung, das Folgendes umfasst:

Generieren aus einem Eingangssignal (704) eines ersten unterabgetasteten Signals (Y5Q) und eines zweiten unterabgetasteten Signals (Y1Q);

Anlegen von ersten und zweiten Gewichtungen an das erste unterabgetastete Signal (Y5Q), um jeweilige erste und zweite gewichtete Signale (818, 820) zu erzeugen;

Anlegen von dritten und vierten Gewichtungen an das zweite unterabgetastete Signal (Y1Q), um jeweilige dritte und vierte gewichtete Signale (826, 828) zu erzeugen;

Kombinieren

des zweiten Signals (Y1Q) und

des ersten gewichteten Signals (818), um ein erstes kombiniertes Signal (Y2D) zu erzeugen;

Erzeugen eines verzögerten ersten kombinierten Signals (Y2Q); Kombinieren

des verzögerten ersten kombinierten Signals (Y2Q),

des zweiten gewichteten Signals (820),

des dritten gewichteten Signals (826) und

des vierten gewichteten Signals (828), um ein zweites kombiniertes Signal (Y3D) zu erzeugen;

Erzeugen eines verzögerten zweiten kombinierten Signals (Y3Q); und

Kombinieren

des verzögerten zweiten kombinierten Signals (Y3Q) und

des zweiten Signals (Y1Q), um ein dezimiertes Ausgangssignal (Y4D) zu erzeugen.

**9.** Verfahren zur Durchführung einer Dezimierung, das Folgendes umfasst:

(a) Durchführen von aufeinanderfolgenden Stufen einer endlichen Impulsantwort- (FIR; Finite Impulse Response) - Dezimierungsfilterung, wobei jede der Stufen der FIR-Dezimierungsfilterung eine Übertragungsfunktion $H(z) = (1+z^{-1})^N$ verwendet, wobei N eine ganze Zahl ist,

**dadurch gekennzeichnet, dass** jede von wenigstens zwei der aufeinanderfolgenden Stufen der FIR-Dezimierungsfilterung eine Mehrphasenfilterung des Verfahrens nach Anspruch 8 umfasst.

10. Verfahren nach Anspruch 9, wobei jede der aufeinanderfolgenden Stufen der FIR-Dezimierungsfilterung eine Dezimierung um einen Dezimierungsfaktor 1 bewirkt, wodurch der Schritt (a) eine Dezimierung um einen Dezimierungsfaktor $I^L$ bewirkt.

11. Verfahren nach Anspruch 9, wobei der Schritt der Mehrphasenfilterung eine Mehrphasen-FIR-Filterung unter Verwendung der Übertragungsfunktion H(z) umfasst.

12. Verfahren nach Anspruch 9, wobei der Schritt der Mehrphasenfilterung Folgendes umfasst:

Erzeugen einer Vielzahl von unterabgetasteten Signalen (Y1Q) aus einem Eingangssignal;
paralleles Erzeugen einer dezimierten Ausgangssignal-Komponente (730a, 730b) aus wenigstens zwei der Vielzahl von unterabgetasteten Signalen (Y1 Q, Y5Q); und
Kombinieren der Vielzahl von dezimierten Ausgangssignal-Komponenten (730a, 730), um ein dezimiertes Ausgangssignal (Y4D) zu erzeugen.

13. Verfahren nach Anspruch 12, wobei der Erzeugungsschritt Folgendes umfasst:

separates FIR-Filtern jedes der unterabgetasteten Signale, um jeweilige FIR-gefilterte Signale zu erzeugen; und
Abwärtsabtasten jedes der FIR-gefilterten Signale, um die dezimierten Ausgangssignal-Komponenten zu erzeugen.

**Revendications**

1.  Filtre de décimation polyphasé (800), comprenant :

un étage d'entrée (802) pour générer, à partir d'un signal d'entrée (704), un premier signal sous-échantillonné (Y5Q) et un deuxième signal sous-échantillonné (Y1Q) ;
des premier et deuxième étages de gain (814, 816) pour appliquer des premier et deuxième poids respectifs au premier signal sous-échantillonné (Y5Q), pour produire des premier et deuxième signaux pondérés (818, 820) respectifs ;
des troisième et quatrième étages de gain (822, 824) pour appliquer des troisième et quatrième poids respectifs au deuxième signal sous-échantillonné (Y1Q), pour produire des troisième et quatrième signaux pondérés (826, 828) respectifs ;
un premier combineur (830) pour combiner
le deuxième signal (Y1Q), et
le premier signal pondéré (818), pour produire un premier signal combiné (Y2D) ;
une première unité de retard (832) pour produire un premier signal combiné retardé (Y2Q) ;
un deuxième combineur (834) pour combiner
le premier signal combiné retardé (Y2Q),
le deuxième signal pondéré (820),
le troisième signal pondéré (826), et
le quatrième signal pondéré (828), pour produire un deuxième signal combiné (Y3D) ;
une deuxième unité de retard (840) pour produire un deuxième signal combiné retardé (Y3Q) ; et
un troisième combineur (842) pour combiner
le deuxième signal combiné retardé (Y3Q), et
le deuxième signal (Y1Q), pour produire un signal de sortie décimé (Y4D).

2.  Système de décimation (500), comprenant :

une pluralité de filtres de décimation à réponse impulsionnelle finie (FIR) en cascade (506a-c, 700, 800), chacun

**EP 1 372 264 B1**

ayant une fonction de transfert H(z) = (1+z$^{-1}$)$^N$, où N est un entier,

dans lequel chacun d'au moins deux de la pluralité de filtres de décimation à réponse impulsionnelle finie en cascade (506a-c, 700, 800) comprend un filtres de décimation à réponse impulsionnelle finie polyphasé (700, 800), **caractérisé en ce qu'**au moins un des filtres polyphasés (700, 800) est le filtre de décimation polyphasé (800) de la revendication 1.

3. Système de décimation (500) selon la revendication 2, dans lequel le filtre de décimation polyphasé (800) selon la revendication 1 comprend :

l'étage d'entrée (802) ayant une entrée, une première sortie et une deuxième sortie ;
les premier et deuxième étages de gain (814, 816) ayant leurs entrées respectives couplées à la première sortie de l'étage d'entrée (802) ;
les troisième et quatrième étages de gain (822, 824) ayant leurs entrées respectives couplées à la deuxième sortie de l'étage d'entrée ;
le premier combineur (830) ayant des entrées respectives couplées à la deuxième sortie de l'étage d'entrée (802) et une sortie du premier étage de gain (814) ;
la première unité de retard (832) ayant une entrée couplée à une sortie du premier combineur (830) ;
le deuxième combineur (834) ayant des entrées respectives couplées à
une sortie de la première unité de retard (832),
une sortie du deuxième étage de gain (816),
une sortie du troisième étage de gain (822),
une sortie du quatrième étage de gain (824) ; et
la deuxième unité de retard (840) ayant une entrée couplée à une sortie du deuxième combineur (834) ; et
le troisième combineur (842) ayant des entrées respectives couplées à
une sortie de la deuxième unité de retard (840), et
la deuxième sortie de l'étage de sortie (802).

4. Système (500) selon la revendication 2, dans lequel chacun des filtres de décimation à réponse impulsionnelle finie (506a-c, 700, 800) est configuré pour effectuer une décimation par un facteur de décimation commun I.

5. Système (500) selon la revendication 2, dans lequel chacun des filtres polyphasés (700, 800) a la fonction de transfert H(z).

6. Système (500) selon la revendication 2, dans lequel chacun des filtres polyphasés (700, 800) est configuré pour recevoir un signal d'entrée respectif, au moins un des filtres polyphasés (700) comprenant :

un étage d'entrée (702) qui génère une pluralité de signaux sous-échantillonnés (Y1Q, Y5Q) à partir du signal d'entrée respectif (502, 704) ;
une pluralité d'étages parallèles de décimation à réponse impulsionnelle finie (704a, 704b), chacun des étages parallèles de décimation à réponse impulsionnelle finie (704a, 704b) pour produire une composante de signal de sortie décimée respective (730a, 730b) à partir d'un respectif de la pluralité de signaux sous-échantillonnés (Y1Q, Y5Q) ; et
un combineur de signaux (706) pour combiner la pluralité de composantes de signal de sortie décimées (730a, 730b) produite par la pluralité d'étages de décimation (704a, 704b), moyennant quoi le combineur (706) produit un signal de sortie décimé (Y4D, 508a-c).

7. Système (500) selon la revendication 6, dans lequel chacun des étages parallèles de décimation à réponse impulsionnelle finie (704a, 704b) comprend :

un filtre à réponse impulsionnelle finie (710a, 710b) ; et
un échantillonneur aval (712a, 712b) suivant le filtre à réponse impulsionnelle finie (710a, 710b).

8. Procédé pour effectuer un filtrage polyphasé, comprenant :

la génération, à partir d'un signal d'entrée (704), d'un premier signal sous-échantillonné (Y5Q) et d'un deuxième signal sous-échantillonné (Y1Q) ;
l'application de premier et deuxième poids au premier signal sous-échantillonné (Y5Q) pour produire des premier et deuxième signaux pondérés (818, 820) respectifs ;
l'application de troisième et quatrième poids au deuxième signal sous-échantillonné (Y1Q), pour produire des troisième et quatrième signaux pondérés (826, 828) respectifs ;
la combinaison
du deuxième signal (Y1Q), et
du premier signal pondéré (818), pour produire un premier signal combiné (Y2D) ;
la production d'un premier signal combiné retardé (Y2Q) ;
la combinaison
du premier signal combiné retardé (Y2Q),
du deuxième signal pondéré (820),
du troisième signal pondéré (826), et
du quatrième signal pondéré (828), pour produire un deuxième signal combiné (Y3D) ;
la production d'un deuxième signal combiné retardé (Y3Q) ; et
la combinaison
du deuxième signal combiné retardé (Y3Q), et
du deuxième signal (Y1Q), pour produire un signal de sortie décimé (Y4D).

9. Procédé pour effectuer une décimation, comprenant :

(a) l'exécution de phases successives de filtrage de décimation à réponse impulsionnelle finie (FIR), chacune des phases de filtrage de décimation à réponse impulsionnelle finie utilisant une fonction de transfert $H(z) = (1+z^{-1})^N$, où N est un entier,

**caractérisé en ce que** chacune d'au moins deux des phases successives de filtrage de décimation à réponse impulsionnelle finie comprend un filtrage polyphasé du procédé de la revendication 8.

10. Procédé selon la revendication 9, dans lequel chacune des phases successives de filtrage de décimation à réponse impulsionnelle finie entraîne une décimation par un facteur de décimation commun I, moyennant quoi l'étape (a) entraîne une décimation par un facteur de décimation $I^L$.

11. Procédé selon la revendication 9, dans lequel ladite étape de filtrage polyphasé comprend un filtrage à réponse impulsionnelle finie polyphasé utilisant la fonction de transfert H(z).

12. Procédé selon la revendication 9, dans lequel ladite étape de filtrage polyphasé comprend :

la génération d'une pluralité de signaux sous-échantillonnés (Y1Q) à partir d'un signal d'entrée ;
la production, en parallèle, d'une composante de signal de sortie décimée respective (730a, 730b) à partir d'au moins deux de la pluralité de signaux sous-échantillonnés (Y1Q, Y5Q) ; et
la combinaison de la pluralité de composantes de signal de sortie décimées (730a, 730) pour produire un signal de sortie décimé (Y4D).

13. Procédé selon la revendication 12, dans lequel ladite étape de production comprend :

le filtrage à réponse impulsionnelle finie séparé des signaux sous-échantillonnés pour produire des signaux filtrés à réponse impulsionnelle finie respectifs ; et
l'échantillonnage aval de chacun des signaux filtrés à réponse impulsionnelle finie, pour produire les composantes de signal de sortie décimées.

EP 1 372 264 B1

100

106

108

102

110

109

104

112

$\dfrac{1}{1-z^{-1}}$    $\dfrac{1}{1-z^{-1}}$    $\dfrac{1}{1-z^{-1}}$    $\dfrac{1}{1-z^{-1}}$

320 KHz

$\downarrow 8$

$1-z^{-1}$    $1-z^{-1}$    $1-z^{-1}$    $1-z^{-1}$

40 KHz

FIG. 1

200

204 206

$x(n)$ → | ↓ M | → | $H(z^{-1})$ | $y(n)$ →

## FIG.2A

220

222 204

$x(n)$ → | $H(z^{-m})$ | → | ↓ M | $y(n)$ →

## FIG.2B

$$H(z)_{CIC} = \left[ \frac{1-z^{-8}}{1-z^{-4}} \ \frac{1-z^{-4}}{1-z^{-2}} \ \frac{1-z^{-2}}{1-z^{-1}} \right]^4 \downarrow 4 \ \downarrow 2 \longleftarrow \text{Eq. (3)}$$

(C) 310

$$H(z)_{CIC} = \left[ \frac{1-z^{-4}}{1-z^{-2}} \ \frac{1-z^{-2}}{1-z^{-1}} \right]^4 \downarrow 4 \left[ \frac{1-z^{-2}}{1-z^{-1}} \right]^4 \downarrow 2 \longleftarrow \text{Eq. (4)}$$

## FIG.3A

$$H(z)_{CIC} = \left[ \frac{1-z^{-4}}{1-z^{-2}} \ \frac{1-z^{-2}}{1-z^{-1}} \right]^4 \downarrow 2 \ \downarrow 2 \left[ \frac{1-z^{-2}}{1-z^{-1}} \right]^4 \downarrow 2 \longleftarrow \text{Eq. (5)}$$

(C) 320

$$H(z)_{CIC} = \left[ \frac{1-z^{-2}}{1-z^{-1}} \right]^4 \downarrow 2 \left[ \frac{1-z^{-2}}{1-z^{-1}} \right]^4 \downarrow 2 \left[ \frac{1-z^{-2}}{1-z^{-1}} \right]^4 \downarrow 2 \longleftarrow \text{Eq. (6)}$$

## FIG.3B

400

( START )

EXPANDING THE CIC FILTER TRANSFER FUNCTION $H(z)_{CIC}$ INTO A PLURALITY OF EXPANSION TERMS (e.g., L TERMS), WHEREIN ONE OR MORE OF THE PLURALITY OF EXPANSION TERMS ARE EACH CAPABLE OF BEING COMMUTED WITH A RESPECTIVE ONE OF ONE OR MORE DECIMATION FACTORS (e.g., EACH OF THE ONE OR MORE TERMS IS OF THE FORM $H_i(z^{-M_i})$, WHERE i IDENTIFIES EACH TERM, EACH $M_i > 1$, AND THE $M_i$ ARE FACTORS OF $I^L$)

405

COMMUTING EACH OF THE ONE OR MORE EXPANSION TERMS WITH THE RESPECTIVE DECIMATION FACTOR (e.g., COMMUTE THE $i^{th}$ TERM WITH $M_i$), TO PRODUCE A PLURALITY OF DECIMATION FILTER TERMS (e.g., L FILTER TERMS, EACH CORRESPONDING TO A DECIMATION FACTOR I)

410

TRANSFORMING THE PLURALITY OF DECIMATION FILTER TERMS INTO A PLURALITY OF FIR DECIMATION FILTER TERMS (FOR EXAMPLE, L FIR DECIMATION FILTER TERMS OF THE FORM $(1+z^{-1})^N$) USING POLYNOMIAL EXPANSIONS.

415

( END )

# FIG.4

EP 1 372 264 B1

500

320KHz → 502 → [$1+4z^{-1}+6z^{-2}+4z^{-3}+z^{-4}$] 506a ↓2 → 160KHz 508a → [$1+4z^{-1}+6z^{-2}+4z^{-3}+z^{-4}$] 506b ↓2 → 80KHz 508b → [$1+4z^{-1}+6z^{-2}+4z^{-3}+z^{-4}$] 506c ↓2 → 40KHz 508c

FIG.5

601 → [$1/z$] 602a → [$1/z$] 602b → [$1/z$] 602c → [$1/z$] 602d →

600

604a (1) 607a
604b (4) 607b
606c (6) 607c
606d (4) 607d
606e (1) 607e

(+) 608a → (+) 608b → (+) 608c → (+) 608d → 610

FIG.6

FIG.7

FIG.8

EP 1 372 264 B1

FIG.9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 6233594 B

**Non-patent literature cited in the description**

• Digital Filters for High Performance Audio Delta-sigma Analog-to-digital and Digital-to-analog Conversions. **KUN LIN et al.** Signal Processing, 1996, 3rd International Conference in Bejing. IEEE, 14 October 1996, 59-63